# EUROPEAN PATENT APPLICATION

(11) **EP 4 510 196 A1**
(43) Date of publication of application: **19.02.2025**
(21) Application number: 22937382.4
(22) Date of filing: 12.04.2022
(51) Int. Cl.: H01L 31/10

(54) **LIGHT-RECEIVING ELEMENT**

(71) Applicant: Nippon Telegraph And Telephone Corporation, Chiyoda-ku Tokyo 100-8116 (JP)
(72) Inventor: NADA Masahiro, Musashino-shi, Tokyo 180-8585 (JP); NAKANISHI Yasuhiko, Musashino-shi, Tokyo 180-8585 (JP); TATSUMI Shoko, Musashino-shi, Tokyo 180-8585 (JP)
(74) Representative: TBK
(86) International application number: PCT/JP2022/017601
(87) International publication number: WO 2023/199403

(57) **Abstract**

There is provided a light receiving element capable of maintaining high speed and high sensitivity without a flip-chip packaging process when the light receiving element is mounted on an optical receiver. The light receiving element includes a first electrode metal formed on a top surface of the substrate, a semiconductor layer bonded to a top surface of the first electrode metal, and a second electrode metal formed on a top surface of the semiconductor layer. The semiconductor layer includes a first semiconductor contact layer, a second semiconductor contact layer, and a semiconductor absorbing layer between the first semiconductor contact layer and the second semiconductor contact layer. The first electrode metal has an extraction path for propagating a signal to an anode electrode or a cathode electrode.

## Description

### Technical Field

The present disclosure relates to a light receiving element, and more specifically, to a light receiving element capable of maintaining high speed and high sensitivity without a flip-chip packaging process when the light receiving element is mounted on an optical receiver.

### Background Art

Semiconductor light receiving elements are used in various applications including optical communications and various sensors. In particular, a semiconductor light receiving element for optical communication needs to increase light receiving sensitivity in order to increase a transmission distance of optical communication and needs to increase a bandwidth in order to realize large communication capacity. In addition, the light receiving element also plays an important role in a radio-over-fiber (RoF) technology in which an analog signal in the optical domain passing through an optical fiber is photoelectrically converted using the light receiving element and emitted as a radio signal in the electrical domain. Since an output current from the light receiving element is related to the strength of the radio signal via an antenna, in addition to having a band sufficiently wide that a carrier frequency which becomes the radio signal can be emitted, the light receiving element is required to have high incidence resistance and a high current output (see, for example, Non Patent Literature 1).

Regarding the light receiving element used for optical communication, typically, a light receiving element, a transimpedance amplifier, an optical fiber, a lens that focuses incident light from an optical fiber on the light receiving element, a waveguide, and the like are integrated in a package and are used as an optical receiver. At that time, in designing the optical receiver, it is important to form the light receiving element to be optically and electrically mounted as easily as possible.

### Citation List

### Non Patent Literature

Non Patent Literature 1: A. Beling et al., "High-power, high-linearity photodiodes", Optica, Vol. 3, Issue 3, pp. 328-338, (2016)
Non Patent Literature 2: E. Higurashi et al., "Au-Au Surface-Activated Bonding and Its Application to Optical Microsensors With 3-D Structure", IEEE Journal of Selected Topics in Quantum Electronics, Vol. 15, Issue 5, (2009)

### Summary of Invention

However, mounting of a light receiving element on an optical receiver has a problem as will be described below. The present disclosure has been made in view of the problem, and an object of the present disclosure is to provide a light receiving element capable of maintaining high speed and high sensitivity without a flip-chip packaging process when the light receiving element is mounted on an optical receiver.

In order to achieve the object, an embodiment of the light receiving element of the present disclosure includes: a substrate; a first electrode metal formed on a top surface of the substrate; a semiconductor layer bonded to a top surface of the first electrode metal; and a second electrode metal formed on a top surface of the semiconductor layer. The semiconductor layer includes a first semiconductor contact layer in contact with the first electrode metal, a second semiconductor contact layer in contact with the second electrode metal, and a semiconductor absorbing layer between the first semiconductor contact layer and the second semiconductor contact layer. The first electrode metal has an extraction path for propagating a signal to an anode electrode or a cathode electrode.

According to this configuration, it is possible to provide a light receiving element applicable without a flip-chip packaging process when being mounted on an optical receiver and capable of maintaining high speed and high sensitivity.

### Brief Description of Drawings

Figs. 1(a) and 1(b) are views for illustrating a typical example of mounting of a light receiving element on an optical receiver.
Figs. 2(a) and 2(b) are side views illustrating a schematic configuration of an optical receiver in which light is incident from a back surface of a light receiving element by using a flip-chip substrate different from a mounting substrate.
Fig. 3 is a view illustrating a schematic configuration of a light receiving element of the present embodiment, where Fig. 3(a) is a cross-sectional view, and Fig. 3(b) is a top view.
Fig. 4 is a view illustrating a method for manufacturing the light receiving element of an embodiment of the present disclosure.
Fig. 5 is a view illustrating a schematic configuration of a light receiving element of another embodiment of the present disclosure, where Fig. 5(a) is a cross-sectional view, and Fig. 5(b) is a top view.
Fig. 6 is a view illustrating a schematic configuration of a light receiving element of still another embodiment of the present disclosure, where Fig. 6(a) is a cross-sectional view, and Fig. 6(b) is a top view.
Fig. 7 is a view illustrating a schematic configuration of a light receiving element of still another embodiment of the present disclosure, where Fig. 7(a) is a cross-sectional view, and Fig. 7(b) is a top view.
Fig. 8 is a view illustrating a schematic configuration of a light receiving element of still another embodiment of the present disclosure, where Fig. 8(a) is a cross-sectional view, and Fig. 8(b) is a top view.

### Description of Embodiments

Hereinafter, various embodiments of the present disclosure will be described in detail with reference to the drawings. The same or similar reference signs denote the same or similar components, and the redundant description thereof may be omitted. Numerical values and materials used in the following description are provided as examples, and other numerical values and other materials can be used for a light receiving element according to embodiments without departing from the gist of the present disclosure.

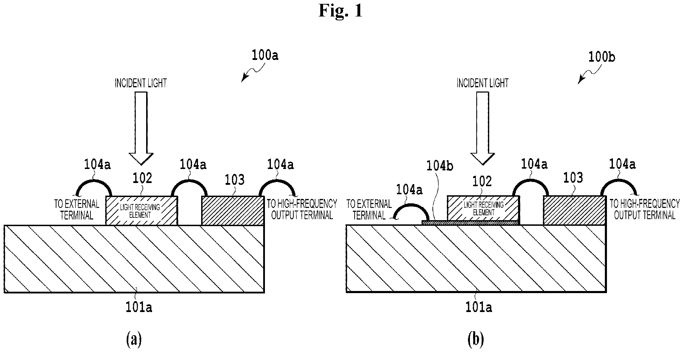

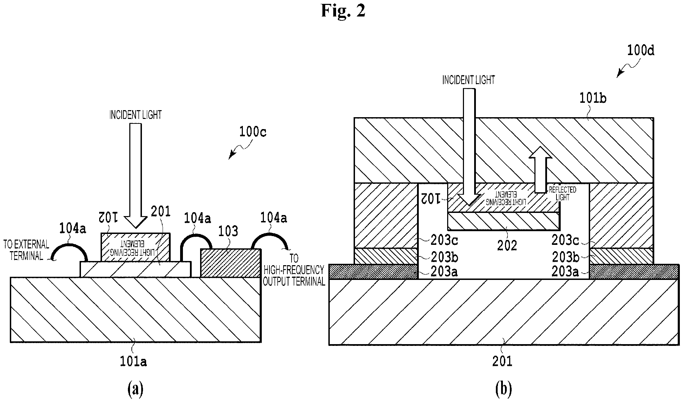

Before the descriptions of the various embodiments of a light receiving element of the present disclosure, a typical example of mounting of a light receiving element on an optical receiver will be described with reference to Figs. 1 and 2.

Fig. 1(a) is a view for illustrating the typical example of mounting of the light receiving element on the optical receiver and is a side view illustrating a schematic configuration of the optical receiver in a form in which light is incident from a front surface of front and back surfaces of the light receiving element (hereinafter, referred to as a front-surface mounting form). An optical receiver 100a illustrated in Fig. 1(a) includes a substrate 101a, a light receiving element 102, and an amplifier 103. As illustrated in the drawing, the light receiving element 102 and the amplifier 103 are mounted on one surface (hereinafter, referred to as a mounting surface) of two main surfaces of the substrate 101a. The light receiving element 102 is connected to an external terminal (not illustrated) and the amplifier 103 via a wiring 104a.

The light receiving element 102 is configured to allow a voltage to be applied from a voltage source connected to the external terminal (not illustrated) via the wiring 104a and output a photoelectrically converted electrical signal to the amplifier 103 via the wiring 104a.

The amplifier 103 is configured to amplify the electrical signal from the light receiving element 102 and output the amplified electrical signal to a processor or the like (not illustrated) connected to the external terminal (not illustrated) via the wiring 104a.

As illustrated in Fig. 1(a), the optical receiver 100a is designed to allow light to be incident from the front surface of the light receiving element 102, and thereby it is possible to have a simple configuration in which the light receiving element 102 is simply disposed on the mounting surface of the substrate 101a.

Fig. 1(b) is a view illustrating another typical example of the front-surface mounting form of the light receiving element on the optical receiver. An optical receiver 100b illustrated in Fig. 1(b) has a configuration different from the configuration of Fig. 1(a) in that the optical receiver 100b includes a wiring 104b provided on the mounting surface of the substrate 101a, and the light receiving element 102 is mounted to be in contact with a front surface of the wiring 104b. A connection position of the wiring 104a for applying a voltage to the light receiving element 102 can be shifted from a top surface of the light receiving element 102 to a top surface of the wiring 104b provided on the front surface of the substrate 101a.

However, in a case of a high-speed/high-sensitivity light receiving element, it is difficult to perform the front-surface mounting. This is because, although the light receiving element needs to have a light receiving window and an electrode on the front surface side, incident light interferes with the electrode, and light receiving sensitivity is impaired in a case where an element diameter is reduced in order to increase the speed of the light receiving element. In addition, in the case of the front-surface mounting, it is difficult to form a reflecting mirror on the substrate side. A light receiving element without a reflection mirror on a surface opposite to a surface on which light is incident has a "one-pass structure" in which incident light passes through a light absorbing layer in the light receiving element only once. In the "one-pass structure", sensitivity extremely deteriorates in a case where the light absorbing layer has a thin thickness. In order to solve such a problem, there is a flip-chip packaging form.

Figs. 2(a) and 2(b) are side views illustrating a schematic configuration of an optical receiver in a form in which light is incident from a back surface of a light receiving element by using a flip-chip substrate different from a mounting substrate (hereinafter, referred to as a flip-chip packaging form). An optical receiver 100c illustrated in Fig. 2(a) has a configuration different from the configurations of Figs. 1(a) and 1(b) in that a flip-chip substrate 201 is provided between a substrate 101a and a light receiving element 102, and the light receiving element 102 is mounted with a front surface thereof facing a top surface of the flip-chip substrate 201. **In** the optical receiver 100c, the light receiving element 102 is configured to output an electrical signal photoelectrically converted from light incident from the back surface, to an amplifier 103 via a wiring 104a.

An optical receiver 100d illustrated in Fig. 2(b) includes a transparent semiconductor substrate 101b, a light receiving element 102 formed on a mounting surface of the semiconductor substrate 101b, a mirror 202 formed on a front surface side (lower side in the drawing) of the light receiving element 102, and a flip-chip substrate 201 facing the mounting surface of the semiconductor substrate 101b. The mounting surface of the semiconductor substrate 101b and a main surface of the flip-chip substrate 201 are connected via the stacked pads 203a, 203b, and 203c. The semiconductor substrate 101b is transparent to incident light. **In** the optical receiver 100d, the light receiving element 102 is configured to output an electrical signal photoelectrically converted from light incident from the back surface via the semiconductor substrate 101b and light reflected by the mirror 202 provided on the front surface.

In the case of the optical receiver of the flip-chip packaging form illustrated in Figs. 2(a) and 2(b), since the incident light is incident from the back surface of the light receiving element, interference due to an electrode can be avoided. Further, since a mirror can be formed on a top surface of the element in a normal light receiving element process, a "two-pass structure" in which the incident light easily passes through an absorbing layer twice can be obtained. However, in the case of the optical receiver 100c of the flip-chip packaging form illustrated in Fig. 2(a), a problem arises in that a mounting process becomes complicated in that the light receiving element 102 is diced once into a state of individual elements, and then is mounted on a main surface of the flip-chip substrate 201, and further the flip-chip substrate 201 is mounted on a main surface of the substrate 101a.

Here, a viewpoint of high input resistance and high output of the light receiving element will be described. As described above, in the application to optical wireless communications such as RoF, the light receiving element needs to receive an optical signal having as high a strength as possible and output a high current. However, the output current of the light receiving element is not necessarily linear with respect to the optical input strength. One cause thereof is an increase in bonding temperature depending on current density in the element.

In the case where light is incident on the light receiving element, a large amount of photocarriers (electron-hole pairs generated by photoexcitation) are generated in the optical element. In a case where the incident light intensity is low, the generated electrons immediately move toward an n-type electrode and the holes immediately move toward a p-type electrode according to the applied voltage. However, in a case where the incident light intensity is high, heat generation is significant due to Joule heat defined by the voltage applied to the light receiving element and the current flowing through the light receiving element. In general, since a saturation rate of electrons and holes decreases as the temperature increases, an output current value is restricted in a state where Joule heat is significant. That is, from the viewpoint of application to the optical wireless communications such as RoF, suppression of heat generation of the light receiving element is an objective.

As described above, in the application of the light receiving element to the optical communication, not only high speed and high sensitivity but also ease of packaging when the light receiving element is mounted on the optical receiver is important. Flip-chip packaging can ensure the high speed and high sensitivity, but from the viewpoint of the mounting process, an additional flip-chip packaging process is required, and thus a problem arises in that the packaging process itself becomes complicated and includes multiple processes. In addition, from the viewpoint of the application to the optical wireless communications such as RoF, a problem arises in that linearity of the output current with respect to the incident light intensity is impaired by Joule heat in the case where the incident light intensity is high.

The present disclosure provides a structure of a light receiving element that does not impair characteristics thereof with respect to the high speed and the high sensitivity while eliminating the need for the flip-chip packaging process in mounting the light receiving element on an optical receiver and improves linearity of the output current in the case where the incident light intensity is high.

### [First Embodiment]

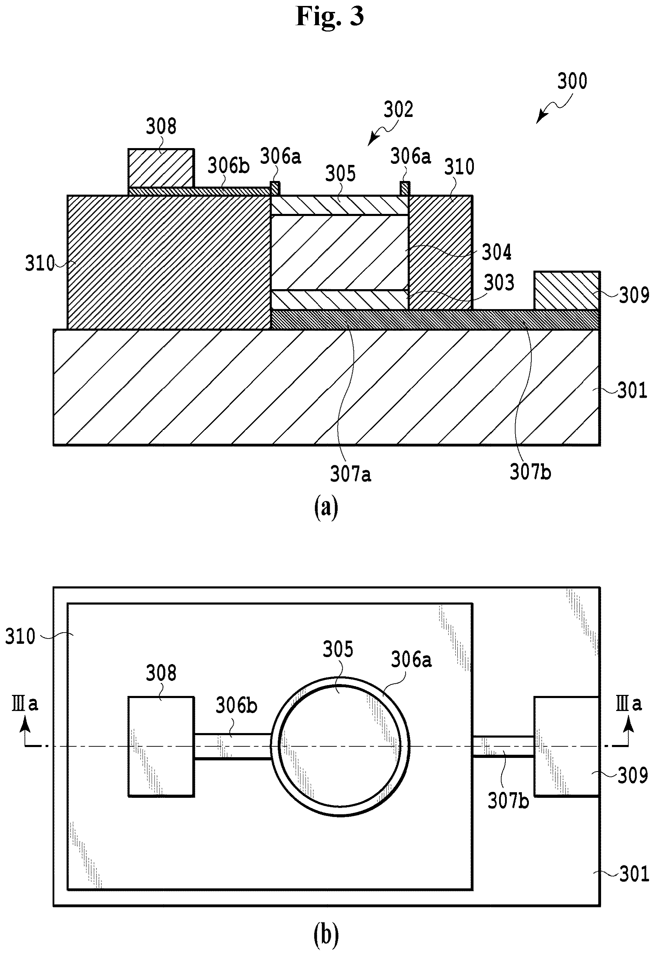

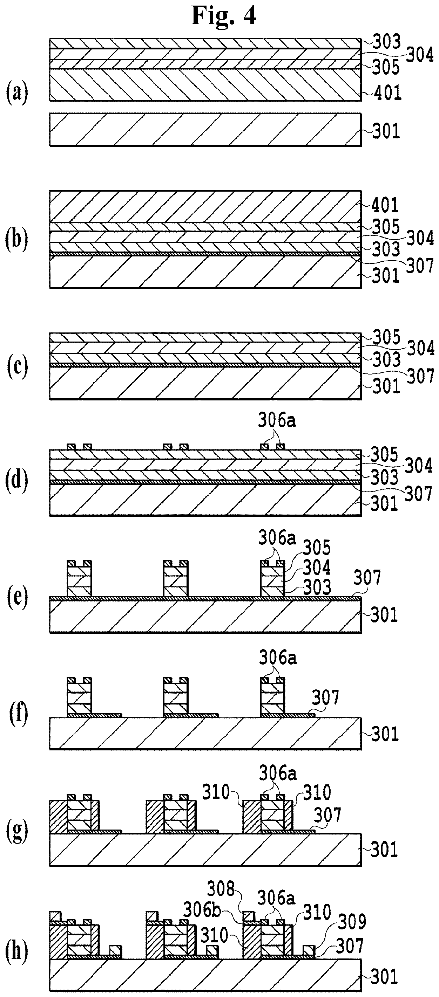

A first embodiment of a light receiving element of the present disclosure will be described with reference to Figs. 3 and 4. The present embodiment is a basic structure in various light receiving elements of the present disclosure. Hereinafter, a light receiving element made of a compound semiconductor will be described as an example.

Fig. 3 is a view illustrating a schematic configuration of the light receiving element of the present embodiment, where Fig. 3(a) is a cross-sectional view, and Fig. 3(b) is a top view. Fig. 4 is a view illustrating a method for manufacturing the light receiving element of the present embodiment.

A light receiving element 300 illustrated in Fig. 3 includes a host substrate 301, an electrode 307 formed on a main surface of the host substrate 301, a semiconductor layer 302, and an electrode 306 formed on a top surface of the semiconductor layer 302. In addition, the light receiving element 300 further includes an interlayer dielectric film 310, an electrode pad 308, and an electrode pad 309.

The semiconductor layer 302 includes an n-type contact layer 303, a light absorbing layer 304, and a p-type contact layer 305 which are laminated in this order.

The electrode 307 includes a bonding portion 307a and an extended portion 307b, and an undersurface of the semiconductor layer 302 is bonded to the host substrate 301 via the bonding portion 307a. Since the electrode 307 is an electrode that bonds the semiconductor layer 302 and the host substrate 301 to each other, the electrode 307 may be referred to as a bonding electrode.

The interlayer dielectric film 310 is formed in contact with a top surface of the host substrate 301 or the electrode 307 and a side surface of the semiconductor layer 302. A position of a top surface of the interlayer dielectric film 310 is the same as a position of the top surface of the semiconductor layer. A material of the interlayer dielectric film 310 can be polyimide.

The electrode 306 is formed on a flat surface including the top surface of the interlayer dielectric film 310 and the top surface of the semiconductor layer. The electrode 306 includes an annular portion 306a and an extended portion 306b which are electrically coupled to each other, the annular portion 306a is formed along an edge of an upper surface of the p-type contact layer 305, and the extended portion 306b is formed on the top surface of the interlayer dielectric film 310. Light is incident from the p-type contact layer of the semiconductor layer 302 via an opening of the annular portion 306a of the electrode 306.

The electrode pad 308 is formed on the top surface of the interlayer dielectric film 310 to be in contact with the extended portion 306b of the electrode 306.

The electrode pad 309 is formed on the top surface of the host substrate 301 to be in contact with the extended portion 307b of the electrode 307.

In the light receiving element 300, a material of the host substrate 301 can be Si, a material of the electrodes 306 and 307 can be Au, and the semiconductor layer 302 can be an epitaxial layer including an InGaAs absorbing layer.

In addition, the n-type contact layer 303, the light absorbing layer 304, and the p-type contact layer 305 constituting the semiconductor layer 302 can be an n-type InP contact layer, an InGaAs absorbing layer, and a p-type InP contact layer, respectively.

A manufacturing method of the present embodiment will be described with reference to Fig. 4. As illustrated in Fig. 4(a), an epitaxial substrate to be the semiconductor layer 302 and an Si substrate to be the host substrate 301 are prepared. Any epitaxial substrate to be the semiconductor layer 302 may be used, as long as the n-type contact layer 303, the light absorbing layer 304, and the p-type contact layer 305 are grown on an InP substrate 401 by using an MOCVD method. In order to bond the n-type contact layer 303 to the host substrate 301 by wafer bonding later, the p-type contact layer 305, the light absorbing layer 304, and the n-type contact layer 303 are crystal-grown in this order on a front surface of the InP substrate 401.

Subsequently, as illustrated in Fig. 4(b), Au to be the electrode 307 is deposited on the front surface of the host substrate 301 in a vacuum chamber, and the epitaxial substrate to be the semiconductor layer 302 is facedown to perform wafer bonding. Au deposited in a film in the vacuum chamber can easily bond the host substrate 301 and the compound semiconductor substrate according to a mechanism of a surface activation method or an atomic diffusion method (see, for example, Non Patent Literature 2).

Subsequently, as illustrated in Fig. 4(c), the InP substrate 401 is peeled from the epitaxial layer by a grinder and wet etching. In a case where a p-type InP substrate is used as the InP substrate 401, a remaining portion of the p-type InP substrate after a part of the p-type InP substrate is peeled from the epitaxial layer functions as the p-type contact layer 305.

Subsequently, as illustrated in Fig. 4(d), the annular portion 306a of the electrode 306 which is in contact with a top surface of the p-type contact layer 305 is formed by EB vapor deposition. Any ring-shaped electrode can be formed using an exposure and development process using a normal resist and a stepper and a lift-off process. In addition, an alignment mark (not illustrated) may be formed in the same step in order to improve accuracy of the subsequent process.

Subsequently, as illustrated in Fig. 4(e), a mesa of the n-type contact layer 303, the light absorbing layer 304, and the p-type contact layer 305 is formed by a resist exposing, developing, and wet-etching process to form the semiconductor layer 302.

Subsequently, as illustrated in Fig. 4(f), Au, which is a metal deposited in a film on the front surface of the host substrate 301, is patterned performing resist exposure, development and dry-etching to form the electrode 307. Au deposited in a film to have the shapes of the electrode pad 309 and the extended portion 307b extending from the bonding portion 307a bonded to an undersurface of the n-type contact layer 303 may be patterned.

Subsequently, as illustrated in Fig. 4(g), the interlayer dielectric film 310 is formed using polyimide which is a photosensitive polymer.

Finally, as illustrated in Fig. 4(h), the extended portion 306b connected to the annular portion 306a of the electrode 306 formed on the top surface of the p-type contact layer 305, the electrode pad 308, and the electrode pad 309 on the extended portion 307b connected to the bonding portion 307a of the electrode 307 bonded to the n-type contact layer 303 are formed by using a resist exposing, developing, and metal-plating process.

Here, an operation principle in the light receiving element of the present disclosure will be described. According to the light receiving element of the present disclosure, the electrode formed at an upper portion of the light receiving element has a ring shape, and thus light can be incident from the upper portion. That is, the front-surface mounting can be performed in the optical receiver. The light incident from the upper portion of the light receiving element is reflected by the bonding portion 307a of the electrode 307 formed by forming the Au film bonded to the n-type contact layer and passes through the light absorbing layer 304 again. That is, it is possible to realize the "two-pass structure" in which light passes through the light absorbing layer 304 twice while being incident on the front surface. At this time, in a case where a film thickness of Au is extremely thin, there is a concern that incident light passes through Au. When the film thickness of Au is 30 nm or more, 95% or more of the incident light can pass through the light absorbing layer 304 again as reflected light.

Further, in the case of group III-V semiconductors represented by the InGaAs absorbing layer, heat dissipation of Joule heat generated at the time of high-intensity input is mainly inhibited by an InP substrate having low thermal conductivity. However, in the light receiving element of the present disclosure, the material of the host substrate 301 constituting the light receiving element is Si having good thermal conductivity at the time of completion of the element. Therefore, the heat dissipation efficiency of Joule heat is remarkably improved, and a high current output can be realized even at the time of high input.

As described above, according to the present embodiment, it is possible to realize the two-pass structure in a front-surface incident state without performing flip-chip packaging on a high-speed high-sensitivity light receiving element on which conventionally the flip-chip packaging needs to be performed, and it is possible to simultaneously realize ease of packaging and the high speed and high sensitivity. Further, since the heat dissipation of the substrate is improved, linearity of the output current with respect to the optical input strength can be realized at the same time.

### [Second Embodiment]

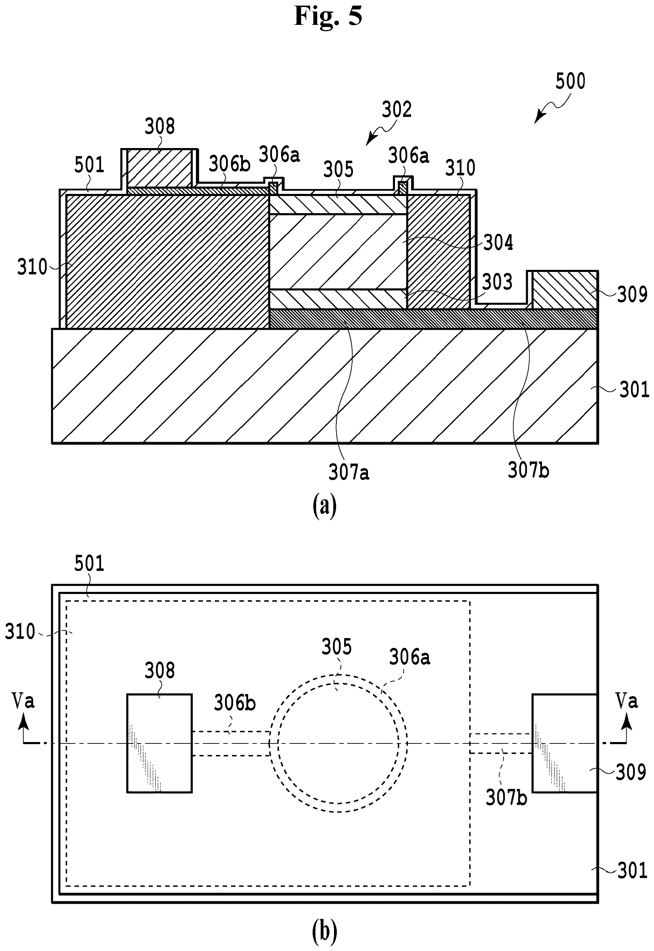

A second embodiment of the light receiving element of the present disclosure will be described with reference to Fig. 5. Fig. 5 is a view illustrating a schematic configuration of the light receiving element of the present embodiment, where Fig. 5(a) is a cross-sectional view, and Fig. 5(b) is a top view.

A light receiving element 500 of the present embodiment differs from the light receiving element 300 of the first embodiment in that a dielectric multilayer film 501 is provided.

As illustrated in Fig. 5, the dielectric multilayer film 501 is formed on a top surface of the light receiving element 500 except for top surfaces of the electrode pads 308 and 309 and protects the top surface of the light receiving element 500. The dielectric multilayer film 501 is configured to minimize the reflectance at a wavelength of light incident on the semiconductor layer 302 and also functions as an antireflection film.

In a method for manufacturing the light receiving element 500 of the present embodiment, as illustrated in Fig. 4(h), after the extended portion 306b of the electrode 306, the electrode pad 308, the extended portion 307b of the electrode 307, and the electrode pad 309 are formed, a multilayer film of TiO2 and SiO2 is formed on the entire surface of a wafer by sputtering. These two types of film thicknesses are individually designed in view of an assumed wavelength of incident light. After the dielectric multilayer film 501 is formed, through-holes are formed only in the top surfaces of the electrode pads 308 and 309 by using a normal photolithography process.

According to the light receiving element 500 of the present embodiment, in addition to the ease of packaging and the high speed and high sensitivity described in the first embodiment and further the improvement in linearity of the output current with respect to the optical input strength, improvement in higher sensitivity by the antireflection film and improvement in environmental resistance reliability by an insulating film on the front surface can be simultaneously realized.

### [Third Embodiment]

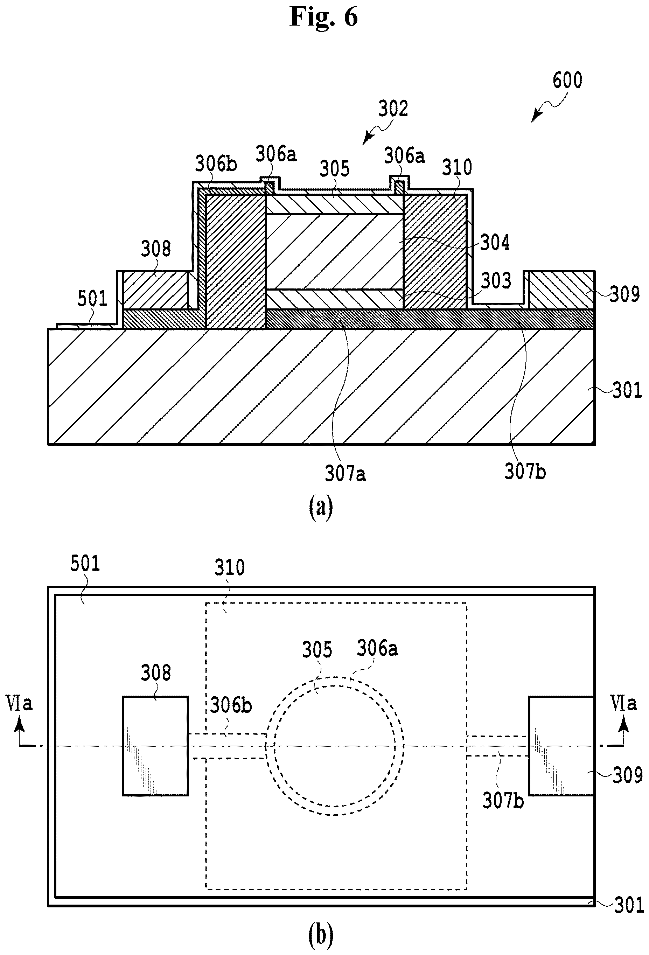

A third embodiment of the light receiving element of the present disclosure will be described with reference to Fig. 6. Fig. 6 is a view illustrating a schematic configuration of the light receiving element of the present embodiment, where Fig. 6(a) is a cross-sectional view, and Fig. 6(b) is a top view.

As illustrated in Fig. 6, in a light receiving element 600 of the present embodiment, a distance between the top surfaces of the electrode pad 308 and the electrode pad 309 and the top surface of the host substrate 301 is smaller than a distance between the top surface of the p-type contact layer 305 and the top surface of the host substrate 301. The light receiving element 600 differs from the light receiving element 500 of the second embodiment in that heights of both the electrode pads 308 and 309 are formed at a position lower than the p-type contact layer 305 positioned at the uppermost portion of the semiconductor layer 302, so that heights of both of an anode and a cathode are aligned.

In a case of evaluating optical response characteristics of an actually prepared light receiving element, an RF probe that ensures transmission of a signal up to tens of GHz is often used. This RF probe is mainly a combination of an integral two-terminal probe in a GS configuration or an integral three-terminal probe in a GSG configuration, and therefore it is often difficult to perform probing when the heights of the anode and cathode are not aligned.

In the light receiving element 600 of the present embodiment, the positions of the electrode pads 308 and 309 are made equal to each other for the probe evaluation as described above.

The method for manufacturing the light receiving element 600 of the present embodiment is designed in advance so that a pattern of the interlayer dielectric film 310 is not applied to the electrode pads 308 and 309 in a process of forming the polyimide interlayer dielectric film 310 (Fig. 4(g)) in the method for preparing the light receiving element 500 illustrated in Fig. 5. After the polyimide interlayer dielectric film 310 is formed, in the process of forming the electrode pad 309 (Fig. 4(h)), Au is patterned from the top surface of the interlayer dielectric film 310 to the top surface of the host substrate 301 by a photolithography process and a plating process to form the extended portion 306b of the electrode 306. Then, the electrode pad 309 is formed on the extended portion 307b of the electrode 307, and the electrode pad 308 is formed on the extended portion 306b of the electrode 306 on the surface of the host substrate 301. Thereafter, a multilayer film of TiO2 and SiO2 is formed on the entire surface of the wafer by sputtering. These two types of film thicknesses are individually designed in view of an assumed wavelength of incident light. After the dielectric multilayer film 501 is formed, through-holes are formed only in the top surfaces of the electrode pads 308 and 309 by using a normal photolithography process.

Also according to the light receiving element 600 of the present embodiment, similarly to the light receiving element 500 illustrated in Fig. 5, it is possible to realize improvement in the ease of packaging, the high speed and high sensitivity, and further the linearity of the output current with respect to the optical input strength. Further, according to the light receiving element 600 of the present embodiment, it is possible to simultaneously realize further improvement in high sensitivity by the antireflection film and improvement in environmental resistance reliability by the insulating film on the surface, and at the same time, it is possible to realize easiness of probing in optical response measurement.

### [Fourth Embodiment]

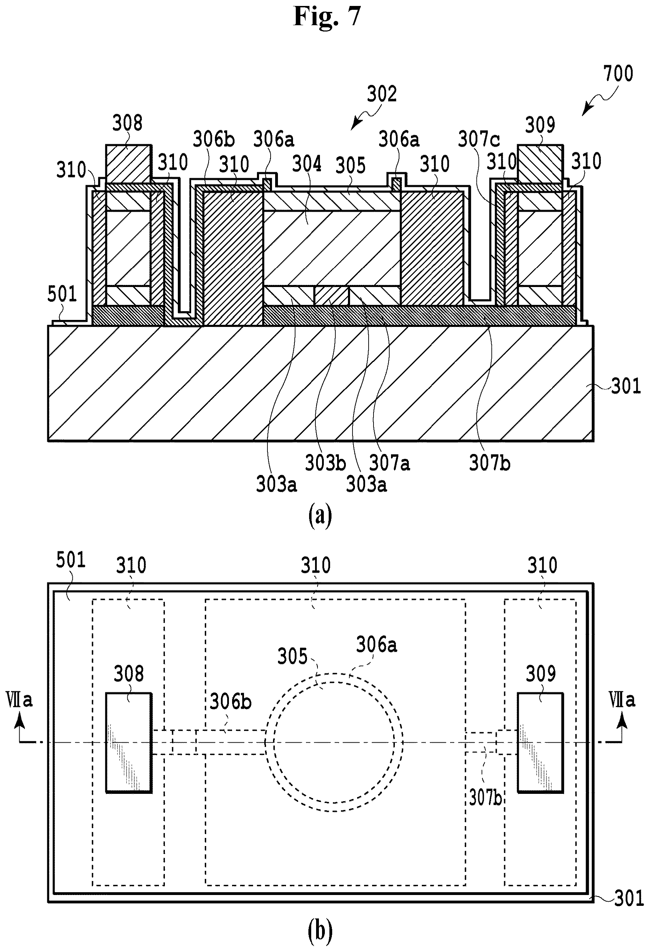

A fourth embodiment of the light receiving element of the present disclosure will be described with reference to Fig. 7. Fig. 7 is a view illustrating a schematic configuration of the light receiving element of the present embodiment, where Fig. 7(a) is a cross-sectional view, and Fig. 7(b) is a top view.

As illustrated in Fig. 7, in a light receiving element 700 of the present embodiment, a distance between undersurfaces of the electrode pad 308 and the electrode pad 309 and the top surface of the host substrate 301 is larger than a distance between the top surface of the p-type contact layer 305 and the top surface of the host substrate 301. The light receiving element 700 differs from the light receiving element 500 of the second embodiment in that heights of both the electrode pads 308 and 309 are formed at a position higher than the p-type contact layer 305 positioned at the uppermost portion of the semiconductor layer 302, so that heights of both of the anode and the cathode are aligned.

Further, the light receiving element 700 of the present embodiment differs from the light receiving element 500 of the second embodiment in that the n-type contact layer 303 of the semiconductor layer 302 which is bonded to the bonding portion 307a of the electrode 307 on the host substrate 301 includes a selectively doped region 303b and an undoped region 303a that is not doped.

As described in relation to the light receiving element 600 of Fig. 6, in the case of evaluating the optical response characteristics of the actually prepared light receiving element, it is desirable that the heights of the electrode pads 308 and 309 be equal at the anode and the cathode. In the light receiving element 700 of the present embodiment, the heights of the electrode pads 308 and 309 are arranged at positions higher than the top surface of the p-type contact layer at the uppermost portion of the semiconductor layer 302.

Further, in a light receiving element that reduces an electric field of a front surface and realizes a low dark current and high reliability, such as an avalanche photodiode (APD), the above-described object is achieved by confining the electric field inside the element and relaxing an electric field of an element side surface.

The light receiving element 700 of the present embodiment realizes electric field confinement by selectively doping the n-type contact layer 303 of the epitaxial layer before the process of bonding the host substrate 301 and the wafer having the semiconductor layer 302 (Fig. 4(b)), for example, in the process of preparing an epitaxial substrate (Fig. 4(a)).

Regarding the method for manufacturing the light receiving element 700 of the present embodiment, for example, in a step of preparing the epitaxial substrate (Fig. 4(a)), the doped region 302b selectively doped is formed in the n-type contact layer 303 as the outermost surface layer of the epitaxial wafer on the semiconductor layer 302 side used at the time of wafer bonding by an ion implantation method of Si, in the method for preparing the light receiving element 500 illustrated in Fig. 5. If the n-type contact layer 303 as the outermost surface layer is a layer having as low an impurity concentration as possible, the effect of the electric field confinement is improved. Typically, undoped InP may be used. Further, in the process of forming the mesa of the n-type contact layer 303, the light absorbing layer 304, and the p-type contact layer 305 by wet-etching to form the semiconductor layer 302 (Fig. 4(e)), the portions for forming the electrode pads 308 and 309 also remain together with the semiconductor layer 302 (mesas are also formed on the right side and the left side of the semiconductor layer 302). After the polyimide interlayer dielectric film 310 is formed (Fig. 4(g)), in the process of forming the electrode pad 309 (Fig. 4(h)), Au is patterned from the top surface of the interlayer dielectric film 310 to the top surface of the left epitaxial layer (including the side surface of the interlayer dielectric film 310 and the front surface of the host substrate 301) which remains together with the semiconductor layer 302 by the photolithography process and the plating process to form the extended portion 306b of the electrode 306. At the same time, Au is patterned from the top surface of the extended portion 307b of the electrode 307 to the top surface of the right epitaxial layer remaining together with the semiconductor layer 302 (including the side surface of the interlayer dielectric film 310 and the front surface of the host substrate 301) to form an extended portion 307c of the electrode 307. The electrode pad 308 is formed on the extended portion 306b, and the electrode pad 309 is formed on the extended portion 307c. Thereafter, a multilayer film of TiO2 and SiO2 is formed on the entire surface of the wafer by sputtering. These two types of film thicknesses are individually designed in view of an assumed wavelength of incident light. After the dielectric multilayer film is formed, through-holes are formed only in a pad portion by using the normal photolithography process.

Also in the light receiving element 700 of the present embodiment, similarly to the light receiving element 600 illustrated in Fig. 6, ease of probing, the low dark current, and high reliability can be realized in addition to the improvement in the ease of packaging, the high speed and high sensitivity, and further the linearity of the output current with respect to the optical input strength.

### [Fifth Embodiment]

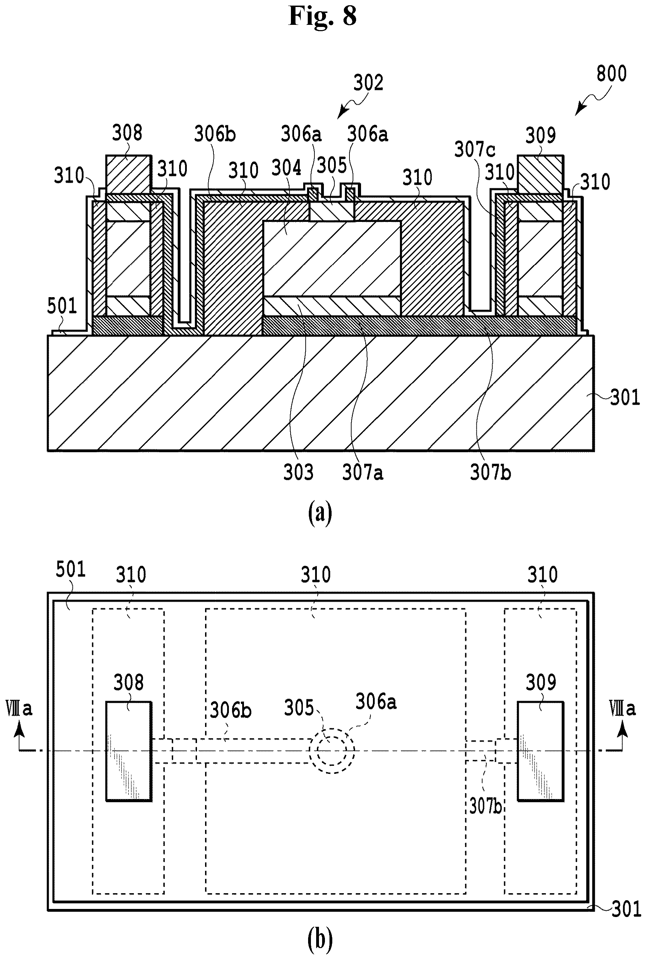

A fifth embodiment of the light receiving element of the present disclosure will be described with reference to Fig. 8. Fig. 8 is a view illustrating a schematic configuration of the light receiving element of the present embodiment, where Fig. 8(a) is a cross-sectional view, and Fig. 8(b) is a top view.

As illustrated in Fig. 8, a light receiving element 800 of the present embodiment realizes a structure for the electric field confinement described in connection with the light receiving element 700 of Fig. 7 by etching processing. As illustrated in Fig. 8, by reducing a diameter of the p-type contact layer 305 of the semiconductor layer 302, an active region in an operating state of the light receiving element 800 is defined, so that no electric field is generated on side surfaces of other layers including the light absorbing layer 304, or the electric field intensity is smaller than that in the central portion.

Regarding a specific method for manufacturing the light receiving element 800 of the present embodiment, in the method for preparing the light receiving element 600 illustrated in Fig. 6, the mesas of the n-type contact layer 303, the light absorbing layer 304, and the p-type contact layer 305 are formed by wet-etching, and the portions for forming the electrode pads 308 and 309 also remain together with the semiconductor layer 302 (mesas also formed on the right side and the left side of the semiconductor layer 302) in the process of forming the semiconductor layer 302 (Fig. 4(e)). Further, additional processing is performed using a photomask so that a diameter of the p-type contact layer 305 becomes smaller than diameters of the light absorbing layer 304 and the n-type contact layer. After the polyimide interlayer dielectric film 310 is formed (Fig. 4(g)), in the process of forming the electrode pad 309 (Fig. 4(h)), the extended portion 306b of the electrode 306 and the extended portion 307c of the electrode 307 are formed, and the electrode pad 309 is formed on the extended portion 307c. The electrode pad 308 is formed on the extended portion 306b, and the electrode pad 309 is formed on the extended portion 307c. Thereafter, a multilayer film of TiO2 and SiO2 is formed on the entire surface of the wafer by sputtering. These two types of film thicknesses are individually designed in view of an assumed wavelength of incident light. After the dielectric multilayer film is formed, through-holes are formed only in a pad portion by using the normal photolithography process.

In the light receiving element 800 of the present embodiment, similarly to the light receiving elements 600 and 700 described above, ease of probing, the low dark current, and high reliability can be realized in addition to the improvement in the ease of packaging, the high speed and high sensitivity, and further the linearity of the output current with respect to the optical input strength.

In the descriptions of the various embodiments of the light receiving element, the substrate using Si has been exemplified as the host substrate 301; however, a substrate using another material may be used instead of Si as long as the material has high mechanical strength and good heat dissipation. As another material, for example, SiC may be used.

In addition, in the descriptions of the various embodiments of the light receiving element, a PIN structure having the InGaAs absorbing layer is exemplified as an epitaxial layer structure of the semiconductor layer 302; however, a UTC-PD structure having a p-type absorbing layer or an APD structure having a multiplication layer or an electric field control layer may be used, for example.

In addition, in the descriptions of the various embodiments of the light receiving element, there is no restriction on a material as long as a film made of the material is a generally used interlayer dielectric film such as BCB exemplifying polyimide as the interlayer dielectric film 310. Further, the dielectric multilayer film 501 functioning as the antireflection film is not limited to SiO2/TiO2, and Ta2O5 or SiN may be used.

In addition, in the descriptions of the various embodiments of the light receiving element, single-layer Au is used as the electrode 307 which is a bonding metal; however, a metal multilayer film such as Ti/Au may be used for improving adhesion.

### Industrial Applicability

There can be provided a light receiving element capable of maintaining high speed and high sensitivity without a flip-chip packaging process when the light receiving element is mounted on an optical receiver.

## Claims

1. A light receiving element comprising:
a substrate;
a first electrode metal formed on a top surface of the substrate;
a semiconductor layer bonded to a top surface of the first electrode metal; and
a second electrode metal formed on a top surface of the semiconductor layer, wherein
the semiconductor layer includes
a first semiconductor contact layer in contact with the first electrode metal,
a second semiconductor contact layer in contact with the second electrode metal, and
a semiconductor absorbing layer between the first semiconductor contact layer and the second semiconductor contact layer, and
the first electrode metal has an extraction path for propagating a signal to an anode electrode or a cathode electrode.

2. The light receiving element according to claim 1, further comprising an antireflection film formed on the second semiconductor contact layer.

3. The light receiving element according to claim 1, wherein the first electrode metal includes gold having a thickness of at least 30 nm.

4. The light receiving element according to claim 1, further comprising:
a first electrode pad connected to the first electrode metal; and
a second electrode pad connected to the second electrode metal, wherein
the first electrode pad and the second electrode pad are formed at positions where a distance between top surfaces of the first electrode pad and the second electrode pad and the top surface of the substrate is smaller than a distance between a top surface of the second semiconductor contact layer and the top surface of the substrate.

5. The light receiving element according to claim 1, further comprising:
a first electrode pad connected to the first electrode metal; and
a second electrode pad connected to the second electrode metal, wherein
the first electrode pad and the second electrode pad are formed at positions where a distance between undersurfaces of the first electrode pad and the second electrode pad and the top surface of the substrate is smaller than a distance between a top surface of the second semiconductor contact layer and the top surface of the substrate.

6. The light receiving element according to claim 1, wherein the first semiconductor contact layer includes a selectively doped region.
